# FASCICULE DE BREVET EUROPEEN

(11) **EP 3 089 300 B1**
(45) Date de publication et mention de la délivrance du brevet: **24.01.2018**
(21) Numéro de dépôt: 16163817.6
(22) Date de dépôt: 05.04.2016
(51) Int. Cl.: H02H 3/08, H02H 3/347, H02H 3/04, G01R 31/327, G01R 15/18, G01R 19/25, H01R 9/26, H01R 31/06, H02H 3/10

(54) **DISPOSITIF DE PROTECTION D'UN RESEAU ELECTRIQUE**
VORRICHTUNG ZUM SCHUTZ EINES STROMNETZES
PROTECTION DEVICE FOR ELECTRICAL NETWORK

(30) Priorité: 30.04.2015 FR 1553905
(43) Date de publication de la demande: 02.11.2016
(73) Titulaire: Schneider Electric Industries SAS, 92500 Rueil-Malmaison (FR)
(72) Inventeur: MARMONIER, Jean, 34130 SAINT AUNES (FR)
(74) Mandataire: Dufresne, Thierry

(56) Documents cités:
- EP-A1- 2 887 482
- FR-A1- 2 936 908

## Description

### Domaine technique de l'invention

Le domaine de l'invention est celui des dispositifs ou relais de protection des circuits électriques, et, plus précisément, des dispositifs de protection des réseaux électriques moyenne et haute tension, de type lignes aériennes, câbles ou liaisons aériens, souterrains ou aéro-souterrains, départs transformateur, départs moteur, etc...

### Etat de la technique

Ces dispositifs de protection ont pour particularité de mesurer en permanence des données électriques, telles que les valeurs de courants et tensions, qui sont fournies par des transformateurs de courant et de tension installés sur des conducteurs du réseau électrique.

Les données électriques sont prélevées sous format analogique sur une pluralité de transformateurs disposés sur le réseau électrique, transmises au dispositif de protection par l'intermédiaire de câbles basse tension, puis converties en format numérique à l'intérieur de ces dispositifs de protection. Ensuite, les dispositifs de protection utilisent des programmes de calcul pour comparer à un instant donné les données électriques mesurées avec des données électriques de référence propres à un fonctionnement déterminé.

En cas de défaillance ou d'anomalie détectée par un dispositif de protection, celui-ci peut donner un ordre d'ouverture ou de fermeture à des interrupteurs ou disjoncteurs de façon à sécuriser le réseau électrique.

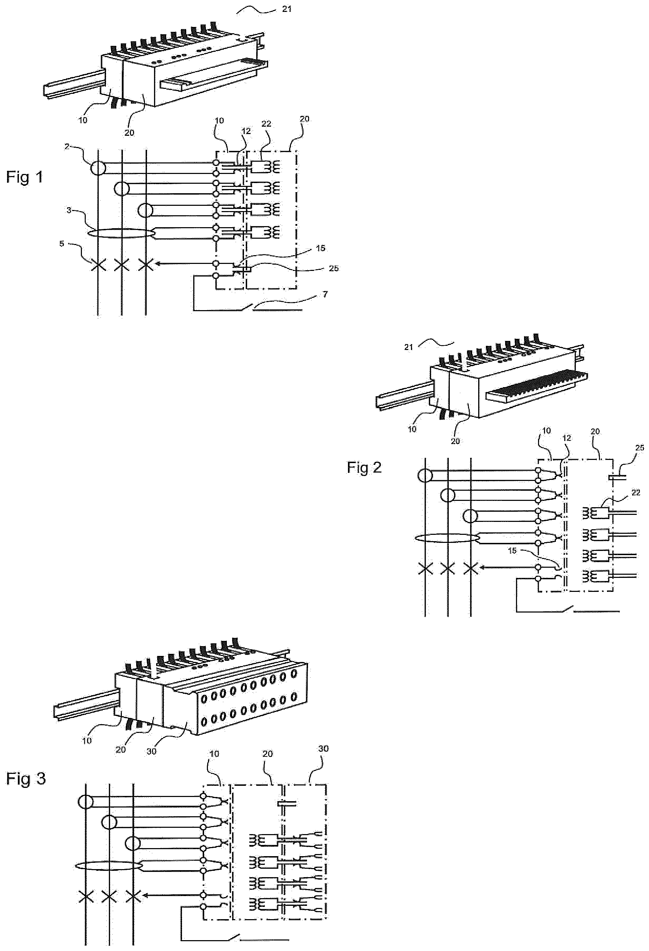

Il est connu du document FR2936908 un dispositif de protection d'un réseau électrique moyenne ou haute tension. Un tel dispositif de protection est montré dans les figures 1 à 3. Il comporte une partie embase 10 qui est raccordée à des transformateurs 2, 3 de courant et/ou de tension, via des liaisons analogiques, pour mesurer des courants/tensions du réseau électrique, et qui est raccordée à un circuit de déclenchement du réseau électrique permettant de transmettre un ordre de déclenchement à un disjoncteur ou un interrupteur 5, notamment en cas de défaut sur le réseau électrique. Le dispositif de protection comporte aussi une partie active 20 qui réalise une conversion analogique-numérique des mesures de courants/tensions venant de la partie embase et qui est reliée via une liaison numérique 21 à une unité centrale de traitement du relais de protection, laquelle est en charge de surveiller les courants/tensions mesurés et de renvoyer si besoin un ordre de déclenchement à la partie active. Si la miniaturisation le permet, la partie active peut être intégrée à l'unité centrale de traitement du relais de protection.

Dans le but de pouvoir faire des essais fonctionnels du relais de protection, le dispositif comporte également une partie essai 30 qui est susceptible de se raccorder à la partie active à la place de la partie embase, de façon à simuler les mesures de courants/tensions faites sur le réseau électrique. Ainsi, en raccordant des moyens externes d'injection de courant/tension à cette partie essai, il est alors possible de tester le fonctionnement du relais de protection pour simuler des transformateurs de courant et de tension. Ces opérations de connexion/déconnexion doivent bien entendu pouvoir se faire en évitant tout ordre de déclenchement intempestif des interrupteurs/disjoncteurs du réseau électrique ou toute mise en danger des opérateurs, notamment lors de la déconnexion des transformateurs de courant.

Pour faire les essais fonctionnels, le dispositif est mis en position test dans laquelle la partie active 20 est déconnectée électriquement de la partie embase 10 et donc des transformateurs de courant et de tension et du circuit de déclenchement. Comme on le voit dans les figures 2 et 3, elle est ensuite retournée de façon à pouvoir d'un côté recevoir la partie essai 30 et de l'autre côté être mécaniquement fixée à la partie embase 10. De la sorte, la partie active 20 continue de recevoir une alimentation électrique venant de la partie embase 10 et peut recevoir une partie essai 30 pour simuler les transformateurs de courant et de tension.

Cependant, le retournement de la partie active pour la placer en position test, génère une manipulation qui s'avère peu intuitive pour un opérateur. De plus, la position test ne permet plus à l'opérateur d'accéder au circuit de déclenchement, car la partie active 20 occulte l'accès à la partie embase 10. Or, il est très utile lors des essais fonctionnels de pouvoir continuer à détecter l'apparition d'un ordre de déclenchement et à vérifier la continuité du circuit de déclenchement.

Un but de l'invention est donc de remédier aux inconvénients indiqués ci-dessus et de faciliter l'utilisation d'un dispositif de protection durant les phases d'essais fonctionnels. En effet, grâce à l'invention, les manipulations pour passer de la position normale à la position test sont plus faciles d'utilisation et très intuitives pour un opérateur. De plus, l'invention permet de conserver un accès rapide au circuit de déclenchement durant la phase de test du dispositif de protection. Un opérateur pourra ainsi se connecter à ce circuit de déclenchement grâce à des bornes externes accessibles.

### Exposé de l'invention

Ce but est atteint par un dispositif de protection d'un réseau électrique moyenne ou haute tension, comprenant une partie embase apte à être connectée à des moyens de mesures de valeurs représentatives du réseau électrique et apte à être connectée à un circuit de déclenchement du réseau électrique, une partie active débrochable qui comporte des moyens de conversion analogique-numérique des valeurs représentatives du réseau électrique et qui est reliée mécaniquement et électriquement à la partie embase dans une première position dite normale, et une partie essai débrochable qui comprend des moyens de connexion mécaniques et électriques à la partie active de telle sorte que, dans une seconde position dite test, la partie active est raccordée à la partie essai et des secondes bornes externes de la partie essai sont raccordées à la partie active pour simuler des mesures de courant ou de tension.

Selon l'invention, la partie essai comprend des moyens de connexion mécaniques et électriques à la partie embase de telle sorte que, en position test, la partie essai est raccordée à la partie embase à la place de la partie active et des premières bornes externes de la partie essai sont apte à être raccordées au circuit de déclenchement au travers de la partie embase.

Selon une première caractéristique, les moyens de mesures comportent des transformateurs de courant permettant la mesure de courants électriques du réseau. Selon une autre caractéristique, les moyens de mesures comportent des transformateurs de tension permettant la mesure de tensions électriques du réseau.

Les moyens de conversion analogique-numérique de la partie active sont apte à être reliés aux moyens de mesures au travers de la partie embase en position normale et aux secondes bornes externes de la partie essai en position test.

La partie embase comporte un logement pour recevoir la partie active en position normale et pour recevoir la partie essai en position test. La partie essai comporte une cavité pour recevoir la partie active en position test.

Selon un mode de réalisation préféré, les premières et les secondes bornes externes de la partie essai sont situées à côté de la cavité.

Dans une variante de l'invention, le dispositif de protection comporte une première partie embase apte à être connectée à des transformateurs de courant pour la mesure de courants électriques du réseau et une seconde partie embase distincte apte à être connectée à des transformateurs de tension pour la mesure de tensions électriques du réseau. Le dispositif de protection comporte une première partie active et une première partie essai coopérant avec la première partie embase, ainsi qu'une seconde partie active et une seconde partie essai coopérant avec la seconde partie embase.

### Brève description des figures

D'autres caractéristiques vont apparaître dans la description détaillée qui suit faite en regard des dessins annexés dans lesquels :
- les figures 1, 2 et 3 montrent, de manière simplifiée et avec le schéma associé, un dispositif de protection connu, la figure 1 représentant le dispositif en position normale, la figure 2 en position retournée et la figure 3 en position essai,
- la figure 4a représente un exemple de dispositif de protection selon l'invention en position normale et la figure 4b donne le schéma associé,
- la figure 5a représente le dispositif de la figure 4a lors du retrait de la partie active et la figure 5b donne le schéma associé,
- la figure 6a représente le dispositif selon l'invention avec les parties embase, active et essai déconnectées et la figure 6b donne le schéma associé,
- la figure 7a représente le dispositif selon l'invention en position test et la figure 7b donne le schéma associé,
- les figures 8a et 8b montrent une variante du dispositif selon l'invention.

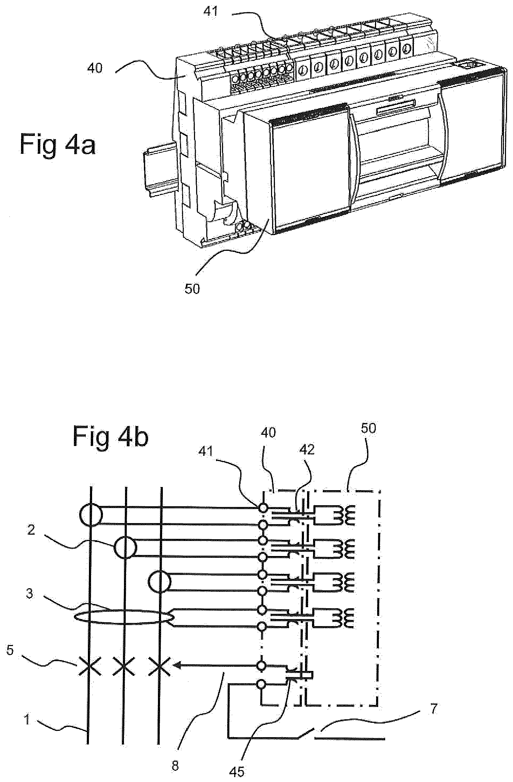

En référence aux figures 4a et 4b, un dispositif de protection d'un réseau électrique triphasé 1 moyenne ou haute tension comporte une partie embase 40 qui est par exemple montée sur un rail DIN. La partie embase 40 est connectée via un bornier interface 41 à des moyens de mesures de valeurs représentatives du réseau électrique 1, telles que les valeurs de courants et tensions. Dans l'exemple de la figure 4, ces moyens de mesures comprennent des transformateurs de courant 2, 3 qui permettent de mesurer des courants circulant dans des conducteurs du réseau électrique 1. Les moyens de mesure sont reliés au bornier interface 41 via des liaisons analogiques. Les moyens de mesures pourraient bien entendu comporter également des transformateurs de tension pour mesurer des tensions du réseau électrique 1.

La partie embase est aussi reliée à un circuit de déclenchement 8 du réseau électrique via le bornier interface 41. De façon connue, un tel circuit de déclenchement 8 permet de commander un disjoncteur 5 en case de défaillance détectée dans le réseau électrique. Dans le circuit de déclenchement 8, l'ordre de déclenchement du disjoncteur 5 est schématisé symboliquement par un contact de déclenchement 7 qui, lorsqu'il est fermé, permet d'alimenter une bobine de déclenchement du disjoncteur 5 de façon à ouvrir le circuit du disjoncteur.

Le dispositif de protection comporte ensuite une partie active 50 qui comprend notamment des moyens de conversion analogique/numérique. Dans une première position dite position normale représentée en figure 4a, la partie active 50 est raccordée mécaniquement et électriquement à la partie embase 40. La partie active 50 vient en effet s'insérer dans un logement 44 de la partie embase 40 de sorte que des broches 42, 45 de la partie embase 40 sont connectées à des broches complémentaires 52, 55 de la partie active 50. La partie active 50 peut donc recevoir les signaux analogiques en provenance des transformateurs de courant 2, 3 au travers de la partie embase 40. Les broches 42, 52 permettent de raccorder les moyens de mesures à la partie active 50 et les broches 45, 55 servent à fermer le circuit de déclenchement 8 via la partie active 50.

Cette position normale correspond au fonctionnement habituel du dispositif de protection. Dans cette position, les signaux numériques générés par la partie active 50 à partir des signaux analogiques de mesures peuvent ainsi être transmis à une unité de traitement (non représentée sur les figures) du dispositif de protection qui les analyse pour prendre les éventuelles décisions nécessaires en cas de défaillance, par exemple fermer le contact de déclenchement 7 de façon à ouvrir le disjoncteur 5.

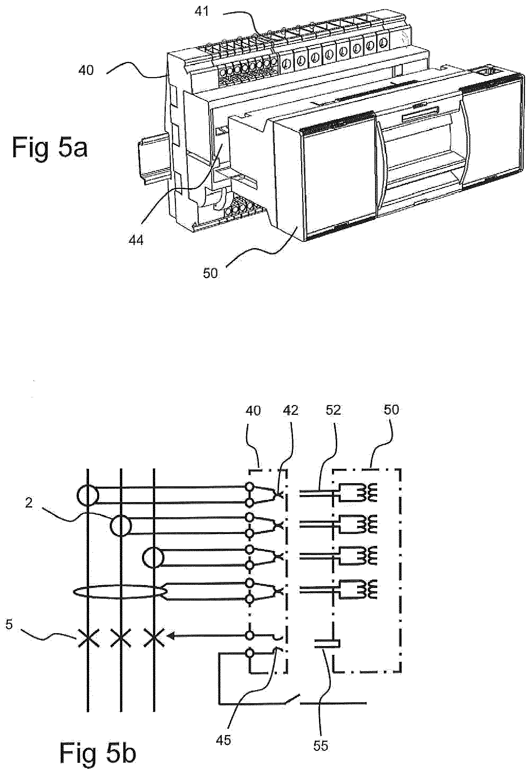

Les figures 5a et 5b montrent la partie active 50 lorsqu'elle est déconnectée de la partie embase 40, c'est-à-dire lorsque la partie active 50 n'est plus insérée dans le logement 44. Dans le cas d'une utilisation de transformateurs de courant 2, 3 pour mesurer le courant dans le réseau électrique, il est important de s'assurer que le circuit électrique des transformateurs de courant n'est pas interrompu lors de la déconnexion de la partie active 50, ce qui engendrerait des problèmes de sécurité importants. C'est pourquoi, les broches 42 sont élastiques et se referment automatiquement l'une sur l'autre pour éviter toute ouverture intempestive du circuit des transformateurs de courant durant le retrait de la partie active 50.

A noter que, au niveau de la partie active 50, les broches 55 du circuit de déclenchement sont plus courtes que les broches 52 des moyens de mesures, de telle sorte que, lors du retrait de la partie active 50, le circuit de déclenchement 8 soit d'abord ouvert avant de déconnecter les moyens de mesures. Sinon, l'unité de traitement du dispositif de protection pourrait détecter une défaillance des mesures qui engendrerait l'apparition intempestive d'un défaut provoquant la fermeture du contact de déclenchement 7 et donc l'ouverture du disjoncteur 5.

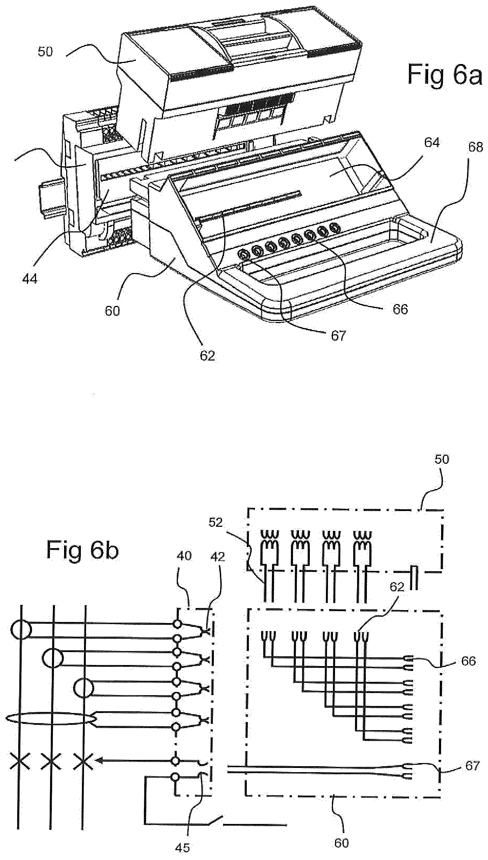

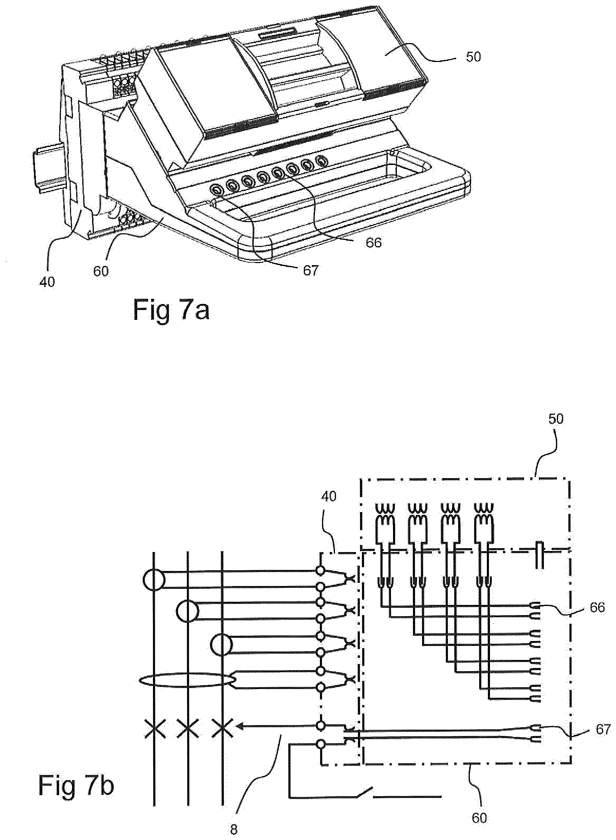

Dans les figures 6a et 7a, le dispositif de protection comporte la partie embase 40, la partie active 50 ainsi qu'une partie essai 60 débrochable. La partie essai 60 est destinée à pouvoir réaliser des essais fonctionnels du dispositif de protection. Elle comporte des bornes externes 66, 67, appelées respectivement premières bornes externes 67 et secondes bornes externes 66, qui sont disponibles pour un opérateur, ainsi qu'une poignée 68 pour la manipuler facilement et une cavité 64 logeant un connecteur 62 pour accueillir la partie active 50. Grâce à la poignée 68, l'utilisation devient très intuitive pour un opérateur, qui, une fois la poignée d'essais en main, comprend immédiatement comment mettre le dispositif de protection en position test.

Lorsque le dispositif de protection est dans une seconde position appelée position test, le but est de déconnecter les moyens de mesures des valeurs représentatives du réseau électrique 1 et de les remplacer par des moyens externes de simulation (non représentés sur les figures) raccordés sur les secondes bornes externes 66 de la partie essai 60, de façon à pouvoir faire des essais fonctionnels du dispositif de protection en simulant des mesures de courant ou de tension.

Dans la position test, la figure 7a montre que la partie essai 60 est fixée mécaniquement à la partie embase 40 en s'insérant dans le logement 44. Des moyens de guidage, tels que rainures, peuvent faciliter cette insertion. La partie essai 60 est également reliée mécaniquement et électriquement à la partie active 50. En effet, la partie active 50 vient s'insérer dans la cavité 64 de la partie essai 60, de façon à ce que les broches 52 de la partie active 50 se raccordent électriquement au connecteur 62. Des moyens de guidage, tels que rainures, peuvent également faciliter cette insertion.

Comme indiqué dans les figures 6b et 7b, les broches 42 de la partie embase 40 ne sont pas raccordées en position test. Seules les broches 45 de la partie embase 40, correspondant au circuit de déclenchement 8, sont connectées électriquement à la partie essai 60 de façon à ce que le circuit de déclenchement 8 soit connecté aux premières bornes externes 67 de la partie essai 60. Pour faciliter un accès facile, un mode réalisation simple est de positionner les premières bornes externes 67, de même que les secondes bornes externes 66, à côté de la cavité 64 les rendant ainsi accessibles à un opérateur en position test, lorsque la partie active 50 est logée dans la cavité 64. Ainsi, à l'aide de ces premières bornes externes 67, un opérateur a avantageusement toujours accès au circuit de déclenchement 8 durant les essais fonctionnels.

Comme indiqué précédemment, les moyens de mesures des valeurs de courants et tensions du réseau électrique 1 peuvent comporter des transformateurs de courant et/ou des transformateurs de tension. Dans l'exemple des figures 4 à 7, ne sont représentés que des transformateurs de courant pour simplifier les figures. Mais on aurait pu envisager de façon équivalente une même partie embase 40 pouvant se raccorder via un seul bornier interface 41 à des transformateurs de courant ainsi qu'à des transformateurs de tension.

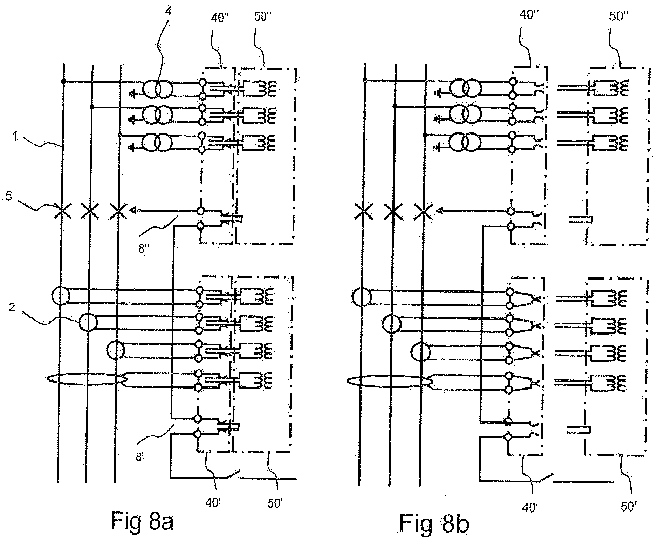

Selon un autre mode de réalisation alternatif schématisé dans les figures 8a et 8b, le dispositif de protection comporte une première partie embase 40' raccordée à des transformateurs de courant 2 via un bornier interface 41' pour mesurer des courants dans le réseau électrique et une seconde partie embase 40" distincte raccordée à des transformateurs de tension 4 via un bornier interface 41" pour mesurer des tensions dans le réseau électrique. Cette séparation en deux parties embase distinctes 40', 40" permet une plus grande modularité et une plus grande souplesse d'utilisation, car permet d'avoir des dispositifs de protection ne mesurant que le courant, d'autres que la tension et d'autres les deux.

Le dispositif de protection selon les figures 8a et 8b comporte donc une première partie active 50' coopérant avec la première partie embase 40' et une seconde partie active 50" distincte coopérant avec la seconde partie embase 40". De façon similaire, un tel dispositif de protection comporte une première partie essai coopérant avec la première partie embase 40' et une seconde partie essai coopérant avec la seconde partie embase 40", non représentées sur les figures. Le circuit de déclenchement d'un tel dispositif de protection est formé par la mise en série d'un premier circuit 8', correspondant à la première partie embase 40', avec un second circuit 8", correspondant à la seconde partie embase 40".

La figure 8a montre le dispositif de protection en position normale avec les partie embases et actives connectées entre elles, alors que la figure 8b montrent les partie embases et actives déconnectées.

## Revendications

1. Dispositif de protection d'un réseau électrique moyenne ou haute tension, comprenant :
- une partie embase (40) apte à être connectée à des moyens de mesures (2, 3) de valeurs représentatives du réseau électrique et apte à être connectée à un circuit de déclenchement (8) du réseau électrique,
- une partie active (50) débrochable qui comporte des moyens de conversion analogique-numérique des valeurs représentatives du réseau électrique et qui est reliée mécaniquement et électriquement à la partie embase (40) dans une première position dite normale,
- une partie essai (60) débrochable qui comprend des moyens de connexion mécaniques et électriques (62) à la partie active (50) de telle sorte que, dans une seconde position dite test, la partie active (50) est raccordée à la partie essai (60) et des secondes bornes externes (66) de la partie essai (60) sont raccordées à la partie active (50) pour simuler des mesures de courant ou de tension,
**caractérisé en ce que** la partie essai (60) comprend des moyens de connexion mécaniques et électriques à la partie embase (40) de telle sorte que, en position test, la partie essai (60) est raccordée à la partie embase (40) à la place de la partie active (50) et des premières bornes externes (67) de la partie essai (60) sont apte à être raccordées au circuit de déclenchement (8) au travers de la partie embase (40).

2. Dispositif de protection selon la revendication 1, **caractérisé en ce que** les moyens de mesures comportent des transformateurs de courant (2, 3) permettant la mesure de courants électriques du réseau.

3. Dispositif de protection selon la revendication 1 ou 2, **caractérisé en ce que** les moyens de mesures comportent des transformateurs de tension (4) permettant la mesure de tensions électriques du réseau.

4. Dispositif de protection selon la revendication 1, **caractérisé en ce que** les moyens de conversion analogique-numérique de la partie active (50) sont apte à être reliés aux moyens de mesures (2, 3) au travers de la partie embase (40) en position normale et aux secondes bornes externes (66) de la partie essai (60) en position test.

5. Dispositif de protection selon la revendication 1, **caractérisé en ce que** la partie embase (40) comporte un logement (44) pour recevoir la partie active (50) en position normale et pour recevoir la partie essai (60) en position test.

6. Dispositif de protection selon la revendication 1, **caractérisé en ce que** la partie essai (60) comporte une cavité (64) pour recevoir la partie active (50) en position test.

7. Dispositif de protection selon la revendication 6, **caractérisé en ce que** les premières et les secondes bornes externes (67, 66) de la partie essai (60) sont situées à côté de la cavité (64).

8. Dispositif de protection selon la revendication 1, **caractérisé en ce qu'**il comporte une première partie embase (40') apte à être connectée à des transformateurs de courant pour la mesure de courants électriques du réseau et une seconde partie embase (40") distincte apte à être connectée à des transformateurs de tension pour la mesure de tensions électriques du réseau.

9. Dispositif de protection selon la revendication 8, **caractérisé en ce qu'**il comporte une première partie active (50') et une première partie essai coopérant avec la première partie embase (40'), ainsi qu'une seconde partie active (50") et une seconde partie essai coopérant avec la seconde partie embase (40").

## Patentansprüche

1. Schutzvorrichtung eines elektrischen Mittel- oder Hochspannungsnetzes, die enthält:
- einen Sockelteil (40), der mit Messeinrichtungen (2, 3) repräsentativer Werte des Stromnetzes und mit einem Auslösekreis (8) des Stromnetzes verbunden werden kann,
- einen abziehbaren aktiven Teil (50), der Einrichtungen zur Analog-Digital-Umwandlung der repräsentativen Werte des Stromnetzes aufweist, und der in einer ersten so genannten normalen Stellung mechanisch und elektrisch mit dem Sockelteil (40) verbunden ist,
- einen abziehbaren Testteil (60), der mechanische und elektrische Verbindungseinrichtungen (62) mit dem aktiven Teil (50) enthält, so dass in einer zweiten so genannten Teststellung der aktive Teil (50) an den Testteil (60) angeschlossen und zweite Außenklemmen (66) des Testteils (60) an den aktiven Teil (50) angeschlossen sind, um Strom- oder Spannungsmessungen zu simulieren,
**dadurch gekennzeichnet, dass** der Testteil (60) mechanische und elektrische Verbindungseinrichtungen mit dem Sockelteil (40) enthält, so dass in der Teststellung der Testteil (60) an den Sockelteil (40) anstelle des aktiven Teils (50) angeschlossen ist, und erste Außenklemmen (67) des Testteils (60) über den Sockelteil (40) an den Auslösekreis (8) angeschlossen werden können.

2. Schutzvorrichtung nach Anspruch 1, **dadurch gekennzeichnet, dass** die Messeinrichtungen Stromwandler (2, 3) aufweisen, die die Messung elektrischer Ströme des Netzes ermöglichen.

3. Schutzvorrichtung nach Anspruch 1 oder 2, **dadurch gekennzeichnet, dass** die Messeinrichtungen Spannungswandler (4) aufweisen, die die Messung elektrischer Spannungen des Netzes ermöglichen.

4. Schutzvorrichtung nach Anspruch 1, **dadurch gekennzeichnet, dass** die Analog-Digital-Umwandlungseinrichtungen des aktiven Teils (50) in normaler Stellung über den Sockelteil (40) mit den Messeinrichtungen (2, 3) und in Teststellung mit den zweiten Außenklemmen (66) des Testteils (60) verbunden werden können.

5. Schutzvorrichtung nach Anspruch 1, **dadurch gekennzeichnet, dass** der Sockelteil (40) eine Aufnahme (44) aufweist, um in normaler Stellung den aktiven Teil (50) und in Teststellung den Testteil (60) aufzunehmen.

6. Schutzvorrichtung nach Anspruch 1, **dadurch gekennzeichnet, dass** der Testteil (60) einen Hohlraum (64) aufweist, um in Teststellung den aktiven Teil (50) aufzunehmen.

7. Schutzvorrichtung nach Anspruch 6, **dadurch gekennzeichnet, dass** die ersten und zweiten Außenklemmen (67, 66) des Testteils (60) sich neben dem Hohlraum (64) befinden.

8. Schutzvorrichtung nach Anspruch 1, **dadurch gekennzeichnet, dass** sie einen ersten Sockelteil (40'), der zur Messung elektrischer Ströme des Netzes mit Stromwandlern verbunden werden kann, und einen zweiten unterschiedlichen Sockelteil (40") aufweist, der zur Messung elektrischer Spannungen des Netzes mit Spannungswandlern verbunden werden kann.

9. Schutzvorrichtung nach Anspruch 8, **dadurch gekennzeichnet, dass** sie einen ersten aktiven Teil (50') und einen mit dem ersten Sockelteil (40') zusammenwirkenden ersten Testteil sowie einen zweiten aktiven Teil (50") und einen mit dem zweiten Sockelteil (40") zusammenwirkenden zweiten Testteil aufweist.

## Claims

1. Device for protecting a medium or high voltage electrical network, comprising:
- a base part (40) able to be connected to means for measuring (2, 3) values representative of the electrical network and able to be connected to a trip circuit (8) of the electrical network;
- a removable active part (50) that comprises means for analogue-digital conversion of the values representative of the electrical network and which is mechanically and electrically connected to the base part (40) in a first position referred to as the normal position;
- a removable test part (60) that comprises mechanical and electrical connection means (62) to the active part (50) so that, in a second position referred to as the test position, the active part (50) is connected to the test part (60) and second external terminals (66) of the test part (60) are connected to the active part (50) in order to simulate current or voltage measures,
**characterized in that** the test part (60) comprises means for mechanically and electrically connecting to the base part (40) such that, in the test position, the test part (60) is connected to the base part (40) in place of the active part (50) and first external terminals (67) of the test part (60) are able to be connected to the trip circuit (8) through the base part (40).

2. Protection device according to Claim 1, **characterized in that** the measuring means comprise current transformers (2, 3) allowing electric currents of the network to be measured.

3. Protection device according to Claim 1 or 2, **characterized in that** the measuring means comprise voltage transformers (4) allowing electric voltages of the network to be measured.

4. Protection device according to Claim 1, **characterized in that** the analogue-digital conversion means of the active part (50) are able to be connected to the measuring means (2, 3) through the base part (40) in the normal position and to the second external terminals (66) of the test part (60) in the test position.

5. Protection device according to Claim 1, **characterized in that** the base part (40) comprises a housing (44) for accommodating the active part (50) in the normal position and for accommodating the test part (60) in the test position.

6. Protection device according to Claim 1, **characterized in that** the test part (60) comprises a cavity (64) for accommodating the active part (50) in the test position.

7. Protection device according to Claim 6, **characterized in that** the first and the second external terminals (67, 66) of the test part (60) are located next to the cavity (64).

8. Protection device according to Claim 1, **characterized in that** it comprises a first base part (40') able to be connected to current transformers for measuring electric currents of the network and a second separate base part (40") able to be connected to voltage transformers for measuring electric voltages of the network.

9. Protection device according to Claim 8, **characterized in that** it comprises a first active part (50') and a first test part interacting with the first base part (40'), as well as a second active part (50") and a second test part interacting with the second base part (40").
